Europäisches Patentamt

European Patent Office

Office européen des brevets

(19)

(11) EP 0 335 284 B1

(12) EUROPÄISCHE PATENTSCHRIFT

(45) Veröffentlichungstag und Bekanntmachung des Hinweises auf die Patenterteilung:
22.05.1996 Patentblatt 1996/21

(51) Int Cl.6: **H03M 1/34**, H04L 27/22, G01R 25/00

(21) Anmeldenummer: 89105332.4

(22) Anmeldetag: 25.03.1989

(54) **Phasen/Digital-Umsetzungsverfahren und Anordnung zur Durchführung des Verfahrens**

Phase to digital conversion method and arrangement for carrying out the method

Procédé de conversion de phase en numérique et agencement pour l'exécution dudit procédé

(84) Benannte Vertragsstaaten:
DE ES FR GB NL

(30) Priorität: 31.03.1988 DE 3811018
29.09.1988 DE 3833005

(43) Veröffentlichungstag der Anmeldung:
04.10.1989 Patentblatt 1989/40

(73) Patentinhaber: Daimler-Benz Aerospace Aktiengesellschaft
D-81663 München (DE)

(72) Erfinder: Zimmer, Manfred, Dr.
D-7900 Ulm (DE)

(74) Vertreter: Schulze, Harald Rudolf, Dipl.-Ing. et al
Daimler-Benz Aerospace AG
Patentabteilung
Sedanstrasse 10
89077 Ulm (DE)

(56) Entgegenhaltungen:
US-A- 3 798 557          US-A- 4 405 895

• PATENT ABSTRACTS OF JAPAN, vol. 6, no. 115 (E-115)(993) 26. Juni 1982;& JP-A-57045764

**Beschreibung**

Die Erfindung betrifft ein Phasen/Digital-Umsetzungsverfahren nach dem Oberbegriff des Patentanspruchs 1 sowie Anordnungen zur Durchführung des Verfahrens.

Derartige Verfahren und Anordnungen sind von Bedeutung für die Anwendung der digitalen Signalverarbeitung mit den bekannten Vorteilen auch auf sehr hochfrequente Signale. Bisher war die sogenannte "Digitalisierung" von hohen und sehr hohen Frequenzen (f > 0,5 GHz) technisch nicht zufriedenstellend zu lösen. Jedoch ist der Bedarf an solchen "Signalquantisierern" (A/D-Umsetzern) für eine Echtzeit-Signalverarbeitung auf dem Gebiet des Satellitenfunks, des Satellitenfernsehens, des Raumfahrtfunks, des Richtfunks, der Radartechnik sowie für digitale Höchstfrequenzempfänger in allen kommerziellen und militärischen Bereichen stark im Wachsen begriffen. Gegenwärtig wird dieser Trend durch das ebenfalls starke Aufkommen von neuen, monolithisch integrierten Mikrowellenschaltkreisen (MMICs) und von digitalen Schaltkreisen (Gigabit-Logik) in FaAs-FET- und Hochgeschwindigkeits-ECL-Technologie maßgeblich unterstützt.

Bei den verfügbaren schnellen A/D-Umsetzern zeigt sich eine Trennung bezüglich des Auflösungsvermögens (Wortlänge) und der Geschwindigkeit (Abtastfrequenz). Die Grenzen der Abtast- bzw. Umsetzungsfrequenzen bei einer Wortlänge von L≤8 Bit liegen gegenwärtig im Bereich von 100 MHz bis 200 MHz und kommen bereits aus diesem Grund für Signale im GHz-Bereich (Mikrowellenbereich) nicht in Frage.

Außerdem haftet diesen schnellen ADUs ein grundsätzlicher, durch die Amplitudenquantisierung bedingter Nachteil an, wobei die Umsetzungsgeschwindigkeit maßgeblich durch den Frequenzvervielfachungseffekt in den einzelnen aktiven ADU-Komponenten begrenzt wird. Er ergibt sich aus der Signalquantisierung an teilperiodischen, sägezahnförmigen oder rampenförmigen Übertragungskennlinien für binärcodierte ADUs bzw. Falt-ADUs. Durch die ca. $2^L$-Perioden (Intervalle) dieser Quantisierungskennlinien wird die Bandbreite $B_s$ eines bandbegrenzten Eingangssignals s(t) innerhalb der ADUs auf maximal eine Bandbreite

$$B_U \geq 2^L \cdot B_s \qquad \text{mit L = ADU-Wortlänge in Bit} \tag{1}$$

bei ADU-Vollaussteuerung vergrößert.

Nun werden heute bei Si-Bipolar-Transistoren Transit frequenzen von ca. 10 GHz erreicht. In einem groben Rechenbeispiel nach Gl. (1) für einen bekannten ADU mit der Wortlänge L = 8 Bit und solchen Transistoren ergibt sich für ein Eingangssignal s(t), das noch fehlerfrei vom ADU umgesetzt werden kann, eine Bandbreite $B_s \leq 50$ MHz.

Dagegen darf die Abtastfrequenz eines derartigen ADUs wesentlich höher als $2 \cdot B_s = 100$ MHz sein. Doch wird dadurch die innere "Quantisierungsgenauigkeit" und Bandbreite des ADUs nicht verbessert.

Um nun diese extremen Bandbreitenanforderungen, die bei der Mikrowellen-Digitalisierung an die einzelnen ADU-Komponenten bei den herkömmlichen Verfahren zu stellen sind, weitgehend zu vermeiden, müssen vom Prinzip her andersartige Verfahren gesucht werden.

Da die relevante Information bei den meisten Hochfrequenz- und Mikrowellensignalen nur in ihren Phasen- bzw. Frequenzverläufen steckt, kann die übliche Amplitudenquantisierung durch eine entsprechend gleichwertige Phasenquantisierung ersetzt werden. Anstatt der Analog/Digital-Umsetzer werden dann Phasen/Digital-Umsetzer benötigt.

Gegenüber der Amplitudendigitalisierung ist die Phasen-digitalisierung bis zu wesentlich höheren Frequenzen bzw. Signalbandbreiten möglich.

In /3/ sind Anordnungen bzw. Verfahren sowohl zur Amplituden - als auch zur Phasen-Digitalisierung beschrieben und gegenübergestellt. Für die Phasen-Digital-Umsetzung wird dabei ausgegangen von einem komplexen Eingangssignal, dessen Inphase (I)- und Quadratur (Q)- Komponenten einem Kombinationsnetzwerk zugeführt sind. Die Ausgangssignale des Kombinationsnetzwerks liegen an den Eingängen einer Mehrzahl von Komparatoren, deren Ausgänge wiederum mit einem Kodierer zur Erzeugung binär codierter Werte für die momentane Signalphase verbunden sind.

Aus der US-A 3,798,557 ist eine Meßanordnung bekannt zur genauen Detektion der Nulldurchgänge von zwei Sinussignalen (Quadratur-Signale), die zueinander eine Phasenverschiebung von ungefähr 90° besitzen. Solche Signale entstehen beispielsweise bei einem Interferometer zwischen einem ausgesandten und einem empfangenen Signal. Aus der Phasenverschiebung kann dann die Entfernung eines Objektes ermittelt werden. Die Phasenverschiebung wird gemessen mittels einer Schaltungsanordnung, die aus den zwei Sinussgnalen mehrere digitale pulsförmige Anzeigesignale erzeugt, welche gegeneinander um einen vorgebbaren Phasenwinkel verschoben sind. Aus diesen Anzeigesignalen entsteht auf einer Kathodenstrahlröhre beispielsweise eine kreisförmige Winkelskala mit äquidistanten Winkelmarkierungen. Aus den Anzeigesignalen wird außerdem ein pulsförmiges Meßsignal erzeugt, welches der Phasenverschiebung entspricht und welches letztendlich der Winkelskala überlagert werden kann. Mittels der dortigen Winkelmarken ist für das Meßsignal eine Winkel-Interpolation möglich, aus welcher die Phasenverschiebung genau bestimmbar ist.

Aus der US-A 4,405,895 ist ein Phasen-Digitalisierungsverfahren für zwei zueinander orthogonale Signale (Quadratur-Signale) bekannt. Diese werden einer ringförmig geschlossenen Reihenschaltung aus einer Vielzahl von Widerständen zugeführt. Zwischen diesen sind elektrische Anschlüsse vorhanden, so daß daran analoge Signale mit vorgebbaren Phasenbeziehungen zueinander entstehen. Letztere werden mittels Komparatoren sowie getakteten Komparatorspeichern in ein getaktetes digitales Phasensignal umgesetzt.

Der Erfindung liegt die Aufgabe zugrunde, ein vorteilhaftes Verfahren zur Phasen/Digital-Umsetzung sowie Anordnungen zur Durchführung dieses Verfahrens anzugeben.

Das erfindungsgemäße Verfahren ist im Patentanspruch 1 beschrieben. Anspruch 4 enthält die Anordnung zur Durchführung des Verfahrens. Die weiteren Ansprüche enthalten vorteilhafte Ausgestaltungen und Weiterbildungen der Erfindung.

Das Verfahrensprinzip ermöglicht Anordnungen zur Durchführung des Verfahrens, die sich besonders zur monolithischen Integration auf einem oder mehreren Halbleiterbausteinen eignen. Da die am Ausgang der Komparatoren parallel abgegebenen Signale bereits ein digitales Phasensignal (eigentlich: Sequenz) darstellen, ist keine analoge Abtastung erforderlich, so daß Abtasthaltekreise oder ähnliche Schaltungen entfallen.

Die Phasendigitalisierung ist besonders vorteilhaft in Verbindung mit Quadratur -Bandpaßsystemen.

Quadratursysteme werden in steigendem Maße eingesetzt, da sie für die digitale Signalverarbeitung gegenüber Einfachsystemen einige technische Vorteile bringen. Die Zeitfunktion s(t) muß zur Signalverarbeitung (z.B. Filterung, Demodulation usw.) innerhalb des Systems als "analytisches Signal" vorliegen. Das analytische Signal ist eine komplexe Größe, die aus dem reellwertigen Signal im Prinzip durch Abschneiden der Spektralanteile bei negativen Frequenzen - Hilbert-Transformation - entsteht. Hier darf die minimale Abtastfrequenz

$$f_A \geq B_s \tag{2}$$

sein. Analytische bzw. komplexe Zeitsignale sind zwar physikalisch nicht möglich, wohl aber ihre Konstruktion aus zwei reellen, zueinander orthogonalen Signalen, von denen man das eine als Realteil (Inphase-Signal) und das andere als Imaginärteil (Quadratur-Signal) interpretiert.

Die komplexe Weiterverarbeitung des komplexen Bandpaßsignals $\underline{s}$ (t) = x(t) + jy(t) kann mit einem Bandpaß im Originalfrequenzbereich betrieben werden (Filterbank) oder im Tiefpaßbereich mit einem Tiefpaß. Wird ein Tiefpaß verwendet, was natürlich viel weniger Aufwand erfordert, so wird der im Basisband liegende Spektralanteil von S(f) mit der vollen Bandbreite $B_s$ genutzt (Empfängerbank).

Die Erfindung ist nachfolgend anhand von Beispielen unter Bezugnahme auf die Abbildungen noch eingehend erläutert.

Dabei zeigt

FIG. 1     eine Gegenüberstellung von Quadratur-Bandpaßsystemen unter Anwendung

          a) eines herkömmlichen Amplituden-Analog/Digital-Umsetzerverfahrens
          b) eines neuartigen Phasen-Digital-Umsetzerverfahrens

FIG. 2     den prinzipiellen Aufbau eines Phasen-Digital-Umsetzers

FIG. 3     ein Beispiel einer Phasenquantisierung bei reellem Eingangssignal

FIG. 4     ein Beispiel einer Phasenquantisierung bei komplexem Eingangssignal

FIG. 5     Vorzeichen der benutzten Gewichtskoeffizienten

FIG. 6     ein Beispiel der Erzeugung von Signalphasen $\phi$i zur Phasenquantisierung

FIG. 7     eine Ausführung eines Phasen-Digital-Umsetzers

FIG. 8     das Prinzip der sukzessiven Phasenwinkel-Halbierung durch Vektor-Addition

FIG. 9     die Erzeugung von Signalphasen $\phi_i$ zur Phasenquantisierung nach dem Prinzip der Phasenwinkel-Halbierung

FIG. 10    eine Ausführung eines Phasen-Digital-Umsetzers mit Phasenwinkel-Halbierung

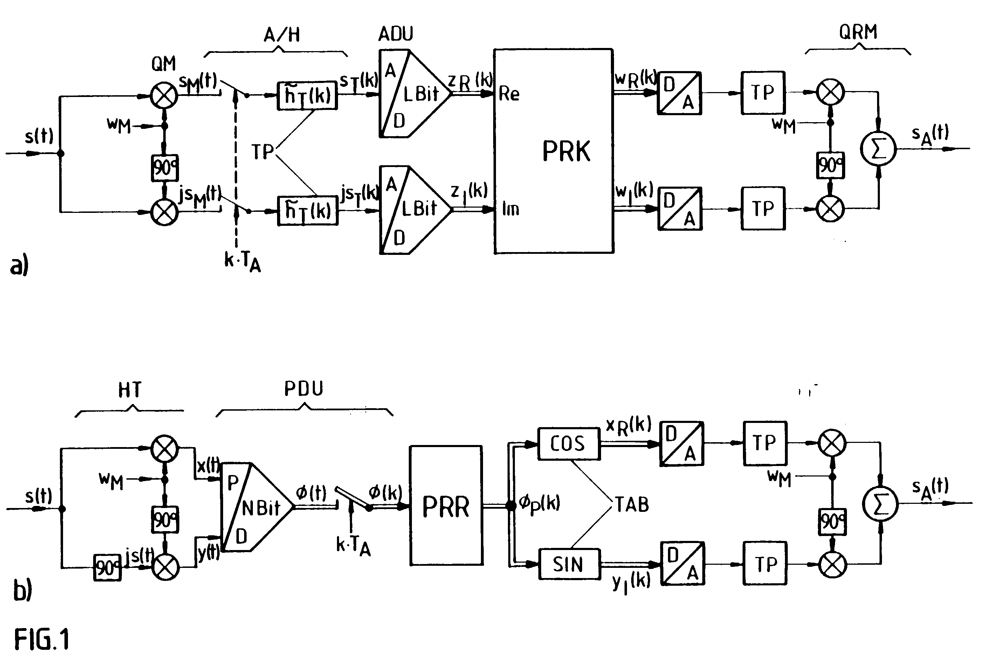

Ein Eingangssignal s(t) wird in FIG. 1a) in einer Quadraturmischeranordnung QM einer Überlagerungsschwingung $w_M$ einmal direkt und einmal mit 90° Phasenverschiebung umgesetzt. Die komplexen Mischerausgangssignale ($s_M$(t) und $js_M$(t)) werden in Abtast- und Halte-Kreisen A/H im Takt des Abtastsignals k-$T_A$ analog abgetastet und über Haltekreis-Tiefpässe TP mit der Filterfunktion $\tilde{h}_{\tau}$(k) in analoge Basisband-Signalfolgen $\tilde{s}_{\tau}$(k) bzw. $\tilde{js}_{\tau}$(k) umgeformt und in Analog-Digital-Umsetzern ADU digitalisiert. Die so gewonnenen Digitalsignale (L Bit Wortlänge) werden als Realteilsignal $z_R$(k) und Imaginärteilsignal $z_I$(k) dem Signalprozessor PRK zugeführt, der als Ausgangssignal i.a. wiederum ein komplexes Digitalsignal $w_R$(k), $w_I$(k) abgibt. Die Signalverarbeitung im Prozessor muß daher komplex durchgeführt werden, was gegenüber einer reellen Signalverarbeitung wesentlich leistungsstärkere Prozessoren erfordert. Das komplexe Ausgangssignal $w_R$(k), $w_I$(k) kann durch Digital-Analog-Umsetzung D/A, Tiefpaßfilterung TP und Quadraturrückmischung QRM in ein reellwertiges Analogsignal $s_A$(t) umgeformt werden. Ein wesentlicher Nachteil dieser Anordnungen ist, wie bereits dargelegt, die durch die Analog-Digital-Umsetzer-Stufen begrenzte Bandbreite.

Bei dem in FIG. 1b) skizzierten System wird aus dem reellwertigen analogen Eingangssignal in einer Hilbert-Transformationsstufe ein komplexwertiges analoges Basisbandsignal mit den Komponenten x(t) und y(t) gewonnen. Die Hilbert-Transformation hat gegenüber der Quadratur-Umsetzung (FIG. 1a)) den Vorteil der Oberwellenfreiheit, so daß Tiefpaßfilter entfallen können. Im übrigen ist aber die Erzeugung der komplexen Basisbandsignale nicht weiter von Bedeutung für die vorliegende Erfindung. Wesentlicher Unterschied des Systems nach FIG. 1b) gegenüber dem in FIG. 1a) skizzierten ist der Phasen-Digital-Umsetzer PDU, welcher mit einer Auflösung von N Bit die Momentanphasen des Eingangssignals als quasi zeitkontinuierliches, digitales Phasensignal $\phi$(t) ausgibt. Dieses digitale Phasensignal kann mit sehr hoher Taktrate $k \cdot T_A$, d.h. sehr kurzer Abtastfolgezeit $T_A$ abgetastet und dabei in eine zeitdiskrete Folge von digitalen Phasenwörtern $\phi$(k) umgesetzt wurden. Die Signalfolge $\phi$(k) wird dem Signalprozessor PRR zugeführt, der als Ausgangssignal eine weitere Folge von digitalen Phasenwörtern $\phi_p$(k) abgibt. Diese Phasenwörter $\phi_p$(k) adressieren eine Cosinus- und eine Sinus-Speichertabelle TAB, so daß wiederum ein komplexes Digitalsignal $x_R$(k), $y_R$(k) vorliegt, das in gleicher Weise wie das komplexe Signal $w_R$(k), $w_I$(k) in FIG. 1a) weiterverarbeitet werden kann. Der Signalprozessor PRR hat nur eine reelle Signalfolge $\phi$(k) zu verarbeiten und kann daher einfacher ausgeführt sein bzw. höhere Datenraten bewältigen als bei der Verarbeitung komplexer Signale.

Grundsätzlich kann jede A/D-Umsetzung im mathematischen Sinn durch ganzzahlige Divisionen

$$z = \text{int} \frac{x}{\stackrel{\circ}{\varphi}} \qquad (3)$$

vollständig beschrieben werden, wobei x die analoge Eingangsgröße und z das Ausgangswort bilden. Die Abkürzung "int" stellt hierbei den Rundungs- bzw. Abbruchoperator für die ganzzahlige Darstellung des Codewortes z dar. Der Divisor,

$$\stackrel{\circ}{\varphi} = A_o \cdot 2^{-N}, \qquad (4)$$

der identisch mit der ADU-Auflösung ist, errechnet sich aus dem ADU-Aussteuerbereich $A_o$ und der ADU-Wortlänge N in Bit.

Dies gilt gleichermaßen auch für die Phasenquantisierung. Die Quantisierung der Phasenwinkel

$$\varphi(t) = \text{arc tan} \frac{v(t)}{x(t)} \qquad (5)$$

eines komplexen Zeitsignals

$$\underline{s}(t) = x(t) + jy(t) = A(t) \cdot e^{+j\varphi(t)} \qquad (6)$$

(oder des konjugiert komplexen Signals

$$\underline{s}^*(t) = x(t) - jy(t) = A(t) \cdot e^{-j\varphi(t)},$$

das z.B. mit Hilfe der Hilbert-Transformation /1/ aus einem rein reellwertigen Zeitsignal s(t) gewonnen wurde (FIG. 1b), erfolgt gemäß der Basisformel für die digitalen Phasenwinkelwerte

$$\varnothing = \text{int} \left\{ \frac{\text{arc tan} \frac{v}{x}}{\Theta} \right\}, \qquad (7)$$

wobei für die Phasenwinkelauflösung

$$\theta = 2\pi \cdot 2^{-N} \qquad (N = \text{Binärstellen in Bit}) \qquad (8)$$

zu setzen ist. Infolge dieser "Rundung" des Phasenwinkels nach Gl. (7) bleibt ein nicht mehr darstellbarer Rest

$$\Delta\theta = \varphi - \theta \cdot \varnothing \qquad (9)$$

übrig, der den systematischen Quantisierungsfehler der Phasenquantisierung beschreibt und im Idealfall sich zwischen den Schranken

$$-\frac{\theta}{2} \leq \Delta\theta \leq +\frac{\theta}{2} \qquad (10)$$

bewegt.

Die technische Umsetzung der Phasenquantisierung auf diesem Weg ist aber nicht ohne weiteres möglich, da für den Fall x = 0 im Argument der arc tan-Funktion in Gl. (7) eine Division durch Null auftritt.

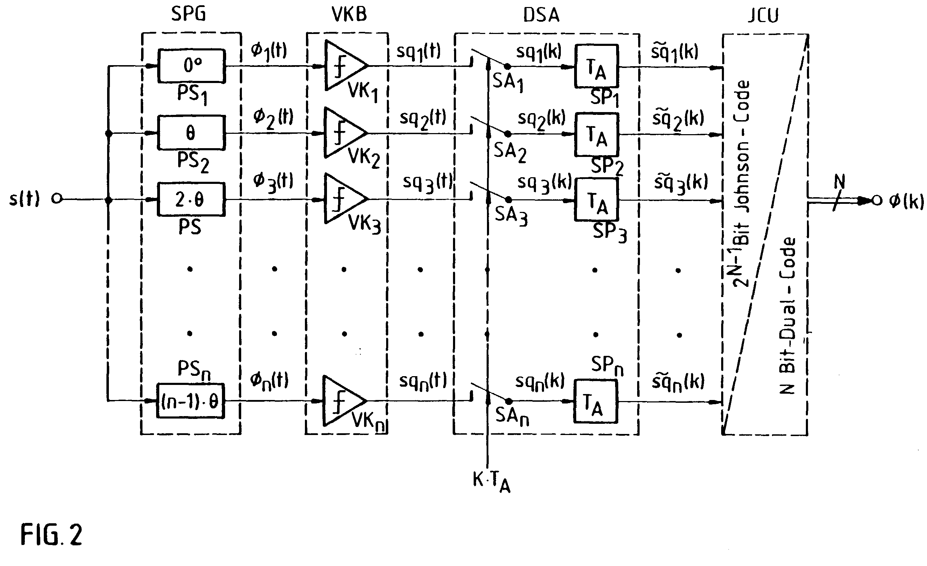

Das Prinzip des erfindungsgemäßen Verfahrens zeigt FIG. 2.

Aus dem Eingangssignal s(t) wird in einem Signalphasengenerator SPG ein Satz von jeweils um gleiche Phaseninkremente θ (Gl. (8)) gegeneinander bzw. gegenüber dem Eingangssignal um Phasenwinkel

$$\theta_i = \theta \cdot (i-1) \tag{11}$$

verschobene, im folgenden als Signalphasen bezeichnete Signale

$$\varnothing_i(\tau) = Re\left\{A(\tau) \cdot e^{j\varphi(\tau)} \cdot e^{-j\theta i}\right\} \tag{12}$$

oder in Real- /Imaginärteil-Schreibweise

$$\phi_i(t) = a_i \cdot x(t) + b_i \cdot y(t) \tag{13}$$

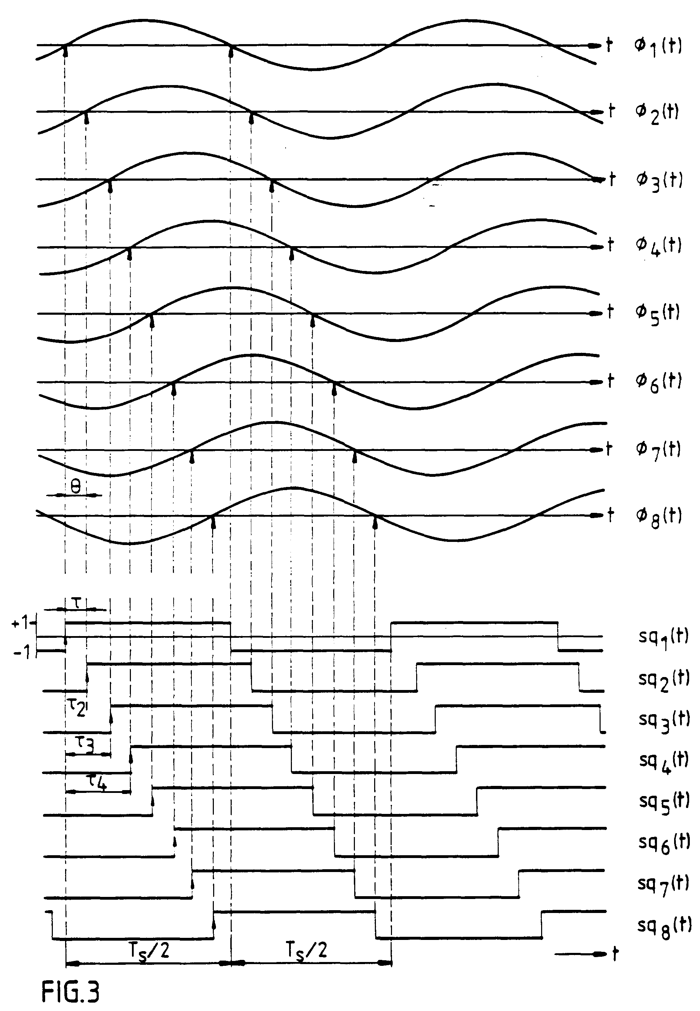

mit i = 1, 2, 3 ... n und n = $2^{N-1}$ erzeugt, was in FIG. 2 durch die Phasenschieber $PS_1$ bis $PS_n$ des Signalphasengenerators SPG angedeutet ist. Die Signalphase $\phi_1(t)$ sei gegenüber dem Eingangssignal nicht phasenverschoben, also $\phi_1(t) = $ s(t). Die Signalphasen $\phi_i$ sind an die Eingänge von Vorzeichenkomparatoren $VK_1$ bis $VK_n$ einer Vorzeichenkompara-torbank VKB angelegt, welche gemäß der Vorzeichenfunktion sgn (Signum) aus den Signalphasen $\phi_i$ einen Satz von Johnson-Sequenzen $sq_i(t)$, i = 1. 2 ... n bildet. Die Signalphasen $\phi_1(t)$ bis $\phi_8(t)$ die durch eine derartige Phasenverschiebung aus einem reellen Eingangssignal gebildet werden, sowie die daraus gewonnenen Johnson-Sequenzen $sq_1(t)$ bis $sq_8(t)$ zeigt die FIG. 3. Johnson-Sequenzen sind in /2/ definiert und eingehend erläutert.

Im Realfall werden die Signalphasen nicht mittels Phasenverschiebung eines reellen Eingangssignals, sondern durch parallele Vektoradditionen von Realteil- und Imaginärteil-Komponente des komplexen Eingangssignals $\underline{s}(t)$ (Gl. (6)) erzeugt. Zur Erzielung einer Phasenverschiebung $\theta_i$ für die Signalphase $\varnothing_i(t)$ müssen die Phasenkoeffizienten $a_i$ und $b_i$ aus Gl. (13) der absoluten Bedingung

$$\frac{b_i}{a_i} = \tan\theta_i \tag{14}$$

genügen. Die Vorschrift der Gl. (14) ist ein wesentliches Merkmal des erfindungsgemäßen Phasen-Digital-Umsetzungsverfahrens und legt die Struktur des Signalphasengenerators SPG im Prinzip fest, was noch im einzelnen erläutert wird.

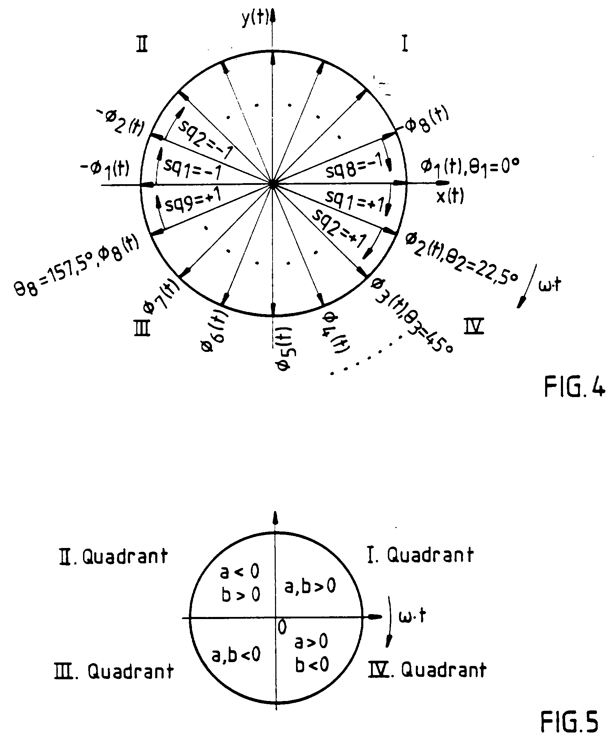

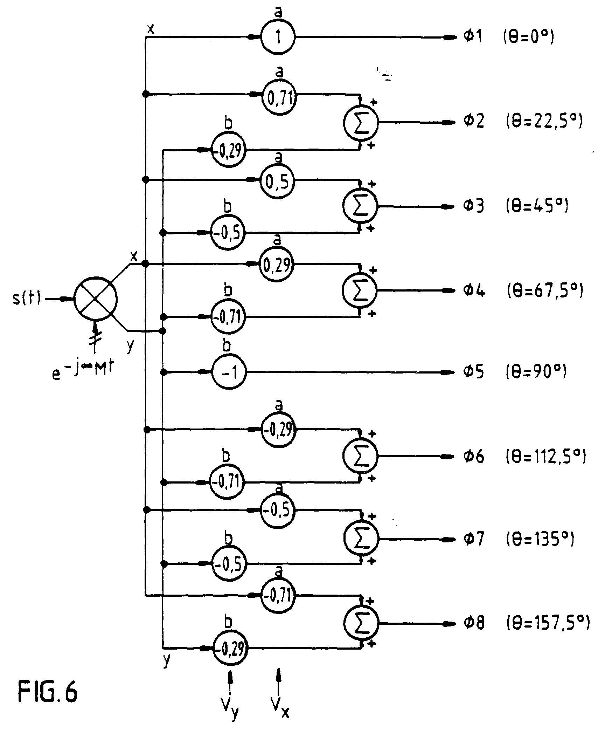

FIG. 4 veranschaulicht die Entstehung der Signalphasen $\phi_i(t)$ aus den Komponenten des komplexen Eingangssignals anhand eines Zeigerdiagramms in der komplexen Ebene mit Realteil x(t) und Imaginärteil y(t) des Signals $\underline{s}(t)$. Im Beispielsfall ist wieder N = 4 entsprechend einer Phasenwinkelauflösung von 22,5° gewählt. Ausgehend von der ersten Signalphase $\phi_1$, die entsprechend $\theta_1 = 0°$ gegenüber dem reellen Eingangssignal bzw. dem Realteil x(t) des komplexen Signals unverschoben ist, liegen die Zeiger der phasenverschobenen Signalphasen $\phi_2$, $\phi_3$ ... bis $\phi_8$ jeweils um θ = 22,5° im Uhrzeigersinn verschoben im unteren Halbraum der komplexen Ebene. Leicht ersichtlich ist aus dieser Darstellung auch, daß zur Unterteilung auch des oberen Halbraums keine weiteren Signalphasen benötigt werden, sondern lediglich die Signalphasen $\phi_1$ bis $\phi_8$ invertiert zu werden brauchen. Ebenfalls im Diagramm eingetragen sind Pegeländerungen der zugehörigen Sequenzen $sq_i(t)$ beim Umlauf mit der Phase des Eingangssignals φ (t) = w·t. Aus dem Diagramm können auch durch einfache geometrische Betrachtungen die Phasenkoeffizienten $a_i$, $b_i$ zur Bildung der Signalphasen $\phi_i$ aus den Komponenten x(t), y(t) durch Vektoraddition abgeleitet werden. Die Vorzeichen der Phasenkoeffizienten in den Quadranten der komplexen Ebene sind in FIG. 5 eingetragen. Die sich ergebenden Johnson-Sequenzen $sq_i(t)$ sind bereits in FIG. 3 dargestellt.

Der Satz der n binärwertigen Johnson-Sequenzen $sq_i(t)$ enthält bereits die Momentanphase des Eingangssignals in phasenquantisierter Form und stellt somit ein zeitkontinuierliches Digitalsignal dar. Zur vollständigen Umsetzung in für die digitale Signalverarbeitung geeignete Form wird nach der Phasenquantisierung noch eine Phasenwert-Abtastung mit dem Abtasttakt k · $T_A$ bzw. der Abtastfrequenz $f_A$ = 1/$T_A$ durchgeführt. Diese digitale Abtastung erfolgt parallel in einem Digital-Sequenz-Abtaster DSA, der der Vorzeichen-Komparatorbank nachgeschaltet ist. Die Abtastung ist in FIG. 2 durch die Schalter $SA_1$ bis $SA_n$ mit nachfolgenden getakteten Speicherzellen $SP_1$ bis $SP_n$ (Taktfolge $T_A$) ver-anschaulicht. Der Digital-Sequenz-Abtaster kann technisch sehr einfach durch schnelle D-Flip-Flops oder ähnliche getaktete Speicherzellen realisiert werden. Die Folgen der bei der parallelen Abtastung gewonnenen Abtastwerte $sq_i$ (k) bilden die zeitdiskreten Sequenzen $sq_i(k)$. Die zeitgleichen Werte $sq_i(k)$ sind die im Johnson-Code vorliegenden digitalen Momentanphasenwerte des Eingangssignals. Zweckmäßigerweise wird dem Digital-Sequenz-Abtaster noch ein Codeumsetzer ICU nachgeschaltet, der die im Johnson-Code mit $2^{N-1}$ Bit Wortlänge anliegenden Digitalwerte in einen zur Weiterverarbeitung besser geeigneten Code, beispielsweise den Binär-Code oder den Gray-Code, mit N Bit Wortlänge umsetzt und als Folge von digitalen Phasenwerten φ(k) ausgibt.

Damit ergibt sich dann für den quantisierten Phasenwert

$$\emptyset(t) = \begin{cases} sq_1(t) = sq(1 \cdot \frac{t}{T_s}) = sgn\ \emptyset_1(t) \\[6pt] sq_2(t) = sq(2 \cdot \frac{t}{T_s}) = sgn\ \emptyset_2(t) \\[6pt] \quad \cdot \qquad \cdot \quad \cdot \qquad\qquad \cdot \\[3pt] \quad \cdot \qquad \cdot \quad \cdot \qquad\qquad \cdot \\[6pt] sq_n(t) = sq(n \cdot \frac{t}{T_s}) = sgn\ \emptyset_n(t) \end{cases} \tag{15}$$

aus den jeweils um $\theta$ gegeneinander phasenverschobenen Signalphasen $\phi_i$ (t) durch die Vorzeichen-Funktion sgn ein Satz von n parallelen, um $\tau_i$ zeitverschobenen Johnson-Sequenzen $sq_1$ bis $sq_n$ (FIG. 3), die hierbei nach der Vorschrift für eine einzige Sequenzperiode mit

$$sq_i(t) = sq(i \cdot \frac{t}{T_s}) = \begin{cases} 1\ \text{für}\ \tau_i \leq t < \tau_i + T_s/2 \\[6pt] -1\ \text{für}\ \tau_i + T_s/2 \leq t < \tau_i + T_s \\[6pt] 0\ \text{für}\ t < \tau_i\ \text{oder}\ t \geq \tau_i + T_s \end{cases} \tag{16}$$

bzw. für die einzelnen Sequenzfolgen $sq_1(k)$ bis $sq_n(k)$ mit

$$sq_i(k) = sq_i(t) \cdot \delta_T(t) = \sum_{K=-\infty}^{\infty} sq_i(\frac{k \cdot t}{T}) \tag{17}$$

festzulegen sind. ($\delta_T(t)$ = Diracstoß-Folge im äquidistanten Abstand T, T = Sequenzdauer). Die Zeitverschiebungen

$$\tau_i = \frac{2\pi}{\theta} \cdot T_s \cdot (i-1) = T_s \cdot 2^{-N} \cdot (i-1) \tag{18}$$

der Johnson-Sequenzen $sq_i(t)$ bzw. $sq_i(k)$ entsprechen damit den Phasenverschiebungen der Signalphasen $\phi_i(t)$ mit der Periodendauer $T_s$ um den Winkel $\theta_i(i - 1)$.

Zur Realisierung des Phasen-Digital-Umsetzungsverrahrens (PDUs) nach dem beschriebenen Grundprinzip der FIG. 2, 3 und 4 werden nachfolgend zwei besonders vorteilhafte Beispiele von Phasen-Digital-Umsetzern (PDU) mit einer Phasenwinkelauflösung von 8 Bit im Johnson-Code bzw. 4 Bit im Binär- oder Gray-Code (N = 4) aufgezeigt, die sich im wesentlichen in den Strukturen ihrer Signalphasengeneratoren (SPG) unterscheiden. Von besonderem Vorteil ist dabei die Möglichkeit, die SPGs voll als monolithisch integrierte Schaltkreise mit der herkömmlichen Si- oder GaAs-Technologie ausführen zu können. Dies bedeutet, daß die einzelnen Komponenten der SPGs selbst vorwiegend durch aktive Bauelemente, z.B. Transistoren, Differenzverstärker usw., leicht realisierbar sind.

Dabei wird jeweils ausgegangen von einem komplexen Eingangssignal $\underline{s}(t)$, das aus einem reellen Signal s(t) durch Quadraturmischung oder Hilbert-Transformation mit einem Signal $e^{-jwMt}$ gewonnen wird und in Form der orthogonalen Signalkomponenten x(t) und y(t) vorliegt (Gl. (6)). Die Erzeugung der Signalphasen $\phi_1(t)$ bis $\phi_8(t)$ erfolgt auf der Grundlage der Vektoraddition (FIG. 4 und 5) aus den orthogonalen Signalkomponenten des komplexen Eingangssignals.

Die verschiedenen Ausführungen der Signalphasengeneratoren SPG erfüllen jeweils die uneingeschränkte Bedingung der Phasenkoeffizienten $a_i$ und $b_i$ nach Gl. (14). Diese legt nur das Verhältnis der Phasenkoeffizienten $b_i$ zu $a_i$ fest und läßt damit für die einzelnen Phasenkoeffizienten noch weitere frei wählbare Nebenbedingungen zu. Dies wird nun in den folgenden Beispielen auf besondere Weise genutzt.

Es ist für die technische Anwendung zweckmäßig, die Phasenkoeffizienten $a_i$ und $b_i$ der Gl. (13) nur Werte annehmen zu lassen, die betragsmäßig kleiner als 1 sind. Dies bewirkt im SPG Signalverstärkungen $|V| \leq 1$, die besonders einfach durch integrierbare, passive oder aktive Komponenten zu realisieren sind.

Im Fall des ersten Beispiels nach FIG. 6 ist für die Koeffizenten eine das Verfahrensprinzip nicht beeinträchtigende Nebenbedingung

$$|a_i| + |b_i| = 1 \tag{19}$$

angenommen. Daraus folgen dann die Bestimmungsgleichungen der Phasenkoeffizienten mit

$$|a_i| = \frac{1}{1 + |\tan\theta_i|} \tag{20}$$

und

$$|b_i| = 1 - |a_i|.$$

Hierbei sind die jeweiligen Vorzeichen für $a_i$ und $b_i$ innerhalb der einzelnen Quadranten der Phasenquantisierung der FIG. 5 zu entnehmen.

Gemäß diesen Gleichungen wird in FIG. 6 das mathematische Übertragungsmodell - eine rein parallele Auffächerung der Signalpfade - eines derartigen SPGs für eine P/D-Umsetzung mit N = 4 aufgezeigt. Hierbei werden die Signallaufzeiten ab der komplexen Signalmischung zu den einzelnen Signalsummationspunkten optimiert. i.h. die einzelnen parallelen Signale durchlaufen nur jeweils eine Verstärkerstufe $V_x$ bzw. $V_y$ mit der Verstärkung $|V_i| \leq 1$ ($V_i = a_i$ bzw. $b_i$).

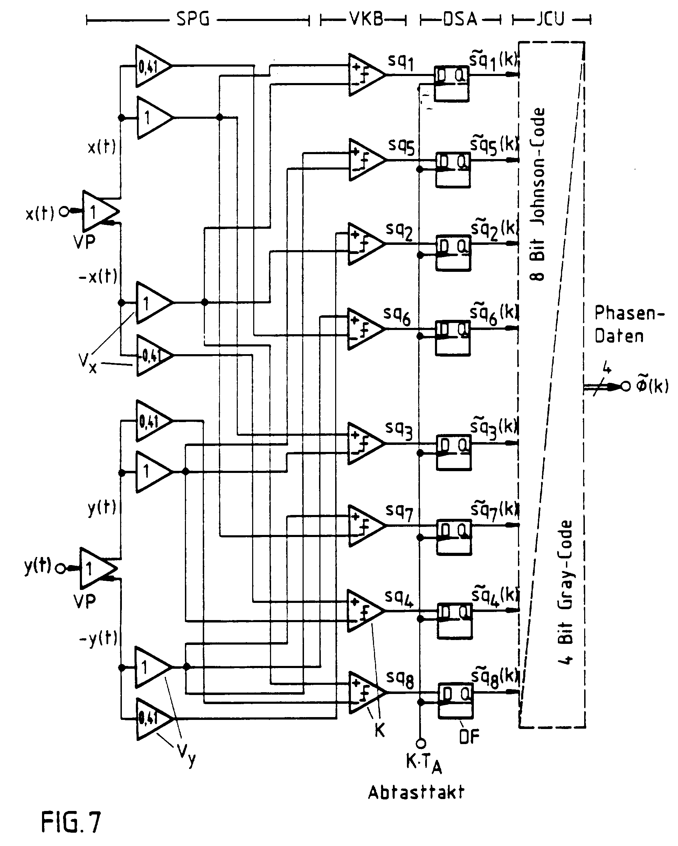

Bei der technischen Realisierung des in FIG. 6 skizzierten prinzipiellen Aufbaus wird vorteilhafter Gebrauch gemacht von der Erkenntnis, daß die in FIG. 6 vorgesehenen Summenbildungen $\phi_i = a_i x + b_i y$ ersetzt werden können durch Differenzbildungen $\phi_i = a_i x_i - (-b_i y) = b_i y - (-a_i x)$, so daß die Summierglieder entfallen können und die stattdessen vorzunehmende Differenzbildung unmittelbar von den Vorzeichenkomparatoren vorgenommen wird, indem die zu substrahierende Signalkomponente $(-a_i x)$ bzw. $(-b_i y)$ an den invertierenden Eingang des jeweiligen Komparators angelegt wird. Die durch Vektoraddition gebildeten Signalphasen treten dann nicht explizit auf, sondern Vektoradditionen und Vorzeichenbildung der Vektorsummen sind dann im inneren Aufbau der Komparatoren impliziert. Weiter wird bei dem Phasen-Digital-Umsetzer nach FIG. 7 ausgenutzt, daß anstelle einer Signalbewertung mit einem negativen Koeffizienten vorteilhafterweise die Signale x(t) und y(t) über Verstärker VP mit einem zusätzlichen invertierten Ausgang geführt und die invertierten Signalanteile mit positiven Koeffizienten bewertet werden. Die Signalbewertung erfolgt in Verstärkerelementen $V_x$ bzw. $V_y$, deren Verstärkungsfaktoren in FIG. 7 eingetragen sind.

Abweichend von FIG. 6 sind nicht die sich aus Gl. (20) ergebenden Koeffizienten übernommen, sondern die Anordnung ist so ausgelegt, daß nur zwei betragsmäßig verschiedene Verstärkungsfaktoren auftreten. Die Bedingung der Gl. (14) ist selbstverständlich auch bei diesem Beispiel erfüllt. Zur gleichmäßigen Belastung aller Ausgänge der Verstärker VP ist noch ein Pufferverstärker P mit negativem Koeffizienten vorgesehen, der bei Verzicht auf diese gleichmäßige Belastung auch mit positivem Koeffizienten an den anderen Ausgang des Signalverstärkers anschließbar wäre. Weitere, in Einzelheiten, insbesondere der Gewichtungsfaktoren und der Zusammenfassung variierende Ausführungen sind denkbar.

Die digitale Abtastung der an den Ausgängen der Komparatoren VK verfügbaren Johnson-Sequenzen $sq_1$ bis $sq_8$ erfolgt dann vorteilhafterweise mit durch das Abtast-Taktsignal $k \cdot T_A$ angesteuerten D-Flip-Flops DF. Die im 8 Bit breiten Johnson-Code vorliegenden Phasenwerte werden in einem Johnson-Code-Umsetzer JCK in beispielsweise den 4 Bit Gray-Code umgesetzt.

Im Fall des zweiten Beispiels nach Bild 8, 9 und 10 wird für die Realisierung des Signalphasengenerators (SPG) ein anderer Weg beschritten, wobei natürlich die Bedingung für die Phasenkoeffizienten (Gl. 14) ebenfalls voll erfüllt ist.

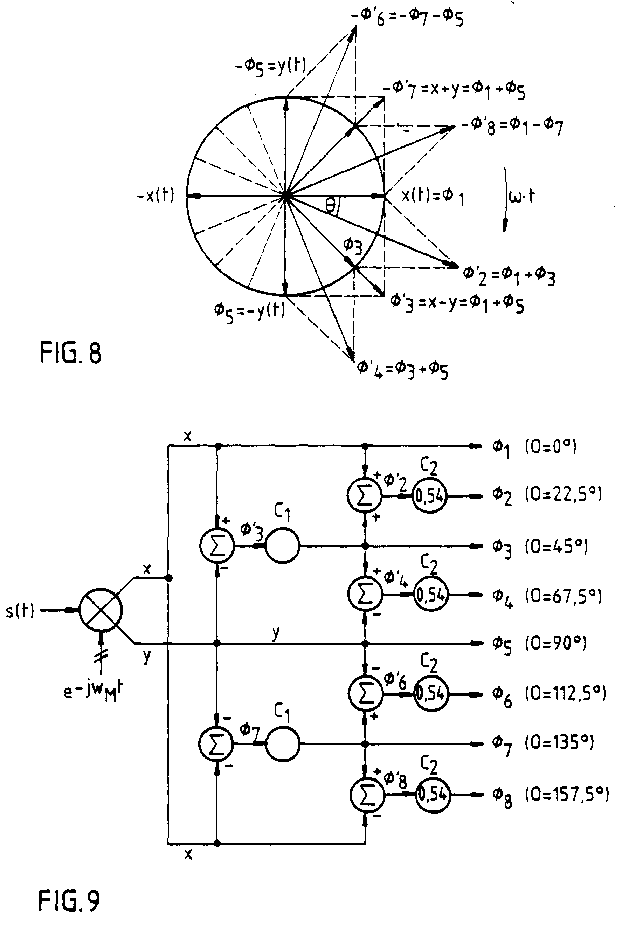

Wesentlicher Unterschied gegenüber dem in FIG. 6 skizzierten prinzipiellen Aufbau des Signalphasengenerators ist die schrittweise Halbierung des Quantisierungs-Phasenwinkels durch Vektoraddition vorliegender Signalphasen zu neuen Signalphasen mit anderen Phasenverzögerungen. Ausgehend von den orthogonalen Komponenten x(t) und y(t), die als Signalphasen einer ersten Quantisierungsstufe mit einer Phasenwinkelauflösung von $\pi/2$ betrachtet werden können, werden durch Vektoraddition neue Signalphasen gebildet, deren Phasenverzögerungen die Phasenwinkelauflösung auf $\pi/4$ halbieren. In dieser Weise wird weiter verfahren, bis die angestrebte Phasenwinkelauflösung erreicht ist. FIG. 8 veranschaulicht das zugrunde liegende Prinzip.

Für eine angestrebte Phasenwinkelauflösung von $\theta = 2\pi \cdot 2^{-N}$ sind erfindungsgemäß $2^{N-1}$ Signalphasen $\phi_i(t)$ zu bilden. Wird $\phi_1(t) = x(t)$ gesetzt, so ergibt sich für N = 4 unmittelbar als weitere Signalphase $\phi_5(t) = -y(t)$. Durch diese beiden Signalphasen wird eine Quadranteneinteilung der komplexen Ebene entsprechend einer Phasenwinkelauflösung von $\pi/2$ erzielt. Durch Vektoraddition werden in einem nächsten Schritt weitere Signalphasen $\phi_3'(t) = \phi_1(t) + \phi_5(t) = x(t) - y(t)$ und $-\phi_7' = \phi_1(t) - \phi_5(t) = x(t) + y(t)$ erzeugt, durch welche die komplexe Ebene weiter in Winkelinkremente $\pi/4$ unterteilt und die vorherige Phasenwinkelauflösung damit halbiert wird. Während die orthogonalen Signalkomponenten x(t) und y(t) bzw. die Signalphasen $\phi_1(t)$ und $\phi_2(t)$ im Regelfall amplitudengleich sind, weisen die durch Vektoraddition gewonnenen Signalphasen $\phi_3'$ und $\phi_7'$ eine um $\sqrt{2}$ höhere Amplitude auf. Bevor in prinzipiell gleicher Weise die Phasenwinkelauflösung weiter halbiert wird, werden die Signalphasen deshalb auf gleiche Amplitude normiert, indem $\phi_3'$ und $\phi_7'$ durch Gewichtung mit dem Faktor

$$C_1 = \frac{1}{2\cos(\pi/4)} \approx 0{,}71$$

auf die normierten Signalphasen $\phi_3$ und $\phi_7$ amplitudenreduziert werden. Aus den nunmehr vorliegenden Signalphasen $\phi_1$, $\phi_3$, $\phi_5$ und $\phi_7$ werden wiederum durch Vektoraddition neue, die Phasenwinkelauflösung weiter auf $\pi/8$ halbierende Signalphasen $\phi_2' = \phi_1 + \phi_3$, $\phi_4' = \phi_3 + \phi_5$ usw, erzeugt, die im Zeigerdiagramm der FIG. 8 eingetragen sind. Damit liegen alle für die angestrebte Phasenwinkelauflösung für N = 4 benötigten Signalphasen vor. Da nur die Vorzeichen der Signalphasen ausgewertet werden, brauchen die zuletzt gebildeten Signalphasen $\phi_2'$, $\phi_4'$, $\phi_6'$ und $\phi_8'$ nicht amplitudennormiert werden. Lediglich für den Fall, daß in einem weiteren Schritt die Phasenwinkelauflösung weiter halbiert werden soll, werden diese Signalphasen durch Wichtung mit einem Skalierungsfaktor

$$C_2 = \frac{1}{2\cos(\pi/8)} \approx 0,54$$

amplitudennormiert.

Für den Aufbau des Signalphasengenerators nach dem beschriebenen Prinzip der sukzessiven Halbierung der Phasenwinkelauflösung ergibt sich damit eine binäre Baumstruktur, wie in FIG. 9 skizziert. Die Erzeugung der orthogonalen Signalkomponenten x(t) und y(t) erfolgt in bereits beschriebener Weise. Für die Vektoradditionen sind Vorzeichen berücksichtigende Summierglieder ($\Sigma$) eingetragen, zur Amplitudennormierung die Skalierungsfaktoren $C_1$ und $C_2$. Da, wie erläutert, die Skalierungen mit $C_2$ bei Beschränkung auf die mit $\phi_1$ bis $\phi_8$ erreichte Phasenwinkelauflösung nicht erforderlich sind, ergibt sich eine Baumstruktur, die mit einem Minimum an Gewichtungskoeffizienten auskommt. Diese Baumstruktur ist aber im Vergleich zu der parallelen Fächerstruktur (FIG. 6) nicht laufzeitminimal zu realisieren.

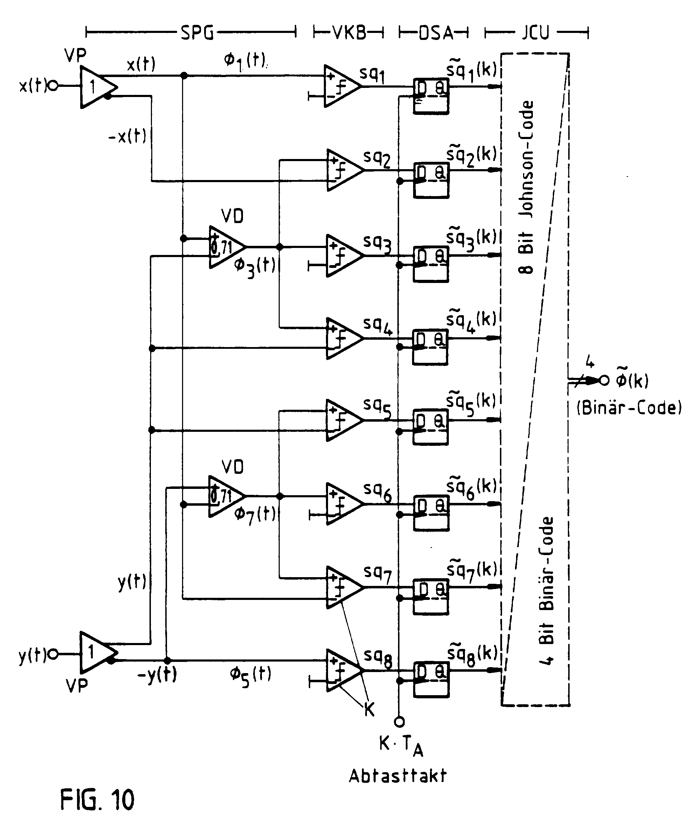

Zur technischen Realisierung eines Phasen-Digital-Umsetzers können dieselben Überlegungen wie bei dem gemäß Fig. 6 und FIG. 7 genutzt werden. Bei dem in FIG. 10 dargestellten Aufbau eines solchen Phasen-Digital-Umsetzers werden in Verstärkern VP aus den orthogonalen Eingangssignalkomponenten x(t) und y(t) zusätzlich dazu invertierte Signale erzeugt. Die Signalphasen $\phi_1(t)$ und $\phi_5(t)$ sind unmittelbar an die Eingänge der zugehörigen Vorzeichenkomparatoren angelegt. Mittels Differenzverstärkern VD mit eingestelltem Verstärkungsfaktor $V = C_1$ werden die Vektoradditionen einschließlich Normierung zur Gewinnung der Signalphasen $\phi_3(t)$ und $\phi_7(t)$ durchgeführt. Die übrigen Vektoradditionen für $\phi_2$, $\phi_4$, $\phi_6$ und $\phi_8$ sind in der zu FIG. 7 beschriebenen Weise mit der Vorzeichenbildung in die Komparatoren K verlegt. Die weitere Verarbeitung mit Abtastung und Code-Umsetzung, hier in dem 4 Bit Binär-Code, erfolgt analog zum Phasen-Digital-Umsetzer der FIG. 7.

Literaturverzeichnis

/1/ H. D. Lüke: Signalübertragung, Springer Verlag, Dritte Auflage, Berlin Heidelberg New York Tokyo, 1985

/2/ K. G. Beauchamp: Applications of Walsh and Related Functions with an Introduction to Sequency Theory, Academic Press, London Orlando San Diego New York Toronto Montreal Sydney Tokyo, 1984

/3/ G. Webber, J. Culp, M. Robinson: DRFM Requirements Demand Innovative Technology, Microwave Journal, Febr. 1986, S. 91 - 104

**Patentansprüche**

1. Phasen/Digital-Umsetzverfahren für phasenmodulierte Signale, bei welchem ein analoges Eingangssignal s(t) in orthogonale Signalkomponenten x(t) und y(t) zerlegt wird und bei welchem zur digitalen Phasenauflösung in $2^N$ gleiche Phaseninkremente $8 = 2\pi \cdot 2^{-N}$, wobei N eine ganze Zahl ist, ein analog arbeitendes Phasennetzwerk (SPG) mit $2^N$ nachgeschalteten Vorzeichenkomparatoren ($VK_1$ bis $VK_n$) verwendet wird,

   - wobei die Vorzeichenkomparatoren ($VK_1$ bis $VK_n$)

      aus verschobenen Signalphasen $\phi_i(t)$ mit $\phi_i(t) = a_i \cdot x(t) + b_i \cdot y(t)$, wobei i = 1 bis $2^{N-1}$ sein kann und wobei für die Gewichtskoeffizienten $a_i$ und $b_i$ die Bedingung $b_i/a_i = \tan\theta_i$, mit $\theta_i = \theta \cdot (i-1)$, gilt, und/oder

      aus den gewichteten Signalkomponenten $a_i \cdot x(t)$, $-a_i \cdot x(t)$, $b_i \cdot x(t)$, $-b_i \cdot x(t)$, für jedes $\phi_i(t)$, mit i = 1 bis $2^{N-1}$, jeweils ein dem Vorzeichen entsprechendes digitales Phasensignal $sq_i$, mit i = 1 bis $2^{N-1}$, erzeugen und

   - wobei die digitalen Phasensignale $sq_i(t)$ zur Phasendemodulation gleichzeitig mit einer Taktrate ($k \cdot T_A$) abgetastet werden, so daß eine zeitdiskrete Folge digitaler Phasenwörter ($\phi(k)$) entsteht.

2. Verfahren nach Anspruch 1, dadurch gekennzeichnet, daß für N>2 die Bildung der Signalphasen $\phi_i$ in mehreren aufeinanderfolgenden Stufen erfolgt, wobei von Stufe zu Stufe das Phaseninkrement halbiert wird und die zu den einzelnen Phasenstufen gehörenden Signalphasen aus skalierten Signalphasen der vorhergehenden Stufe gewonnen werden.

3. Verfahren nach Anspruch 1 oder 2, dadurch gekennzeichnet, daß die digitalen Phasensignale $sq_i(t)$ mit einer Abtastfrequenz, die mindestens gleich der Bandbreite des Eingangssignals $\underline{s}(t)$ ist, abgetastet werden.

4. Anordnung zur Durchführung des Verfahrens nach Anspruch 1, die aufweist

- eine Mischeranordnung (QM) zur Erzeugung orthogonaler Signalkomponenten $x(t)$, $y(t)$ aus einem analogen Eingangssignal $\underline{s}(t)$,

- eine Anordnung aus einem analog arbeitenden Phasennetzwerk (SPG) und $2^N$ nachgeschalteten Vorzeichen-komparatoren ($VK_1$ bis $VK_n$), wobei die Vorzeichenkomparatoren ($VK_1$ bis $VK_n$) aus dem Phasennetzwerk (SPG)

    verschobene Signalphasen $\phi_i(t)$ mit
    $\phi_1(t) = a_i \cdot x(t) + b_i \cdot y(t)$, wobei $i = 1$ bis $2^{N-1}$ sein kann und wobei für die Gewichtskoeffizienten $a_i$ und $b_i$ die Bedingung $b_i/a_i = \tan\theta_i$, mit $\theta_i = \theta \cdot (i-1)$, gilt, und/oder
    gewichtete Signalkomponenten $a_i \cdot x(t)$ , $-a_i \cdot x(t)$ , $b_i \cdot x(t)$ , $-b_i \cdot x(t)$

    erhalten und für jedes $\phi_i(t)$ mit $i = 1$ bis $2^{N-1}$ jeweils ein dem Vorzeichen entsprechendes Phasensignal $sq_i(t)$, mit $i = 1$ bis $2^{N-1}$, erzeugen und

- einen Digital-Sequenz-Abtaster (DSA), welcher die digitalen Phasensignale $sq_i(t)$ mit einer Taktrate ($k \cdot T_A$) zur Phasendemodulation abtastet.

5. Anordnung nach Anspruch 4, dadurch gekennzeichnet, daß die orthogonalen Signalkomponenten $x(t)$ und $y(t)$ im analog arbeitenden Phasennetzwerk (SPG) jeweils parallel an mehreren Amplitudenwichtungsgliedern ($V_x$, $V_y$, VD) anliegen zur Erzeugung gewichteter Signalkomponenten $a_i \cdot x(t)$ und $b_i \cdot y(t)$ sowie dazu invertierter Signalkomponenten $-a_i \cdot x(t)$ und $-b_i \cdot y(t)$.

6. Anordnung nach Anspruch 4 oder 5, dadurch gekennzeichnet, daß die Amplitudenwichtungsglieder aktive Verstärkungselemente mit vorgegebenen Verstärkungsfaktoren sind.

7. Anordnung nach Anspruch 4, dadurch gekennzeichnet, daß zur Zusammenfassung zweier Signalphasen der jeweils vorhergehenden Stufe und zur Skalierung der daraus resultierenden Signalphase Differenzverstärker (VD) mit innerhalb einer Stufe gleichem Verstärkungsfaktor vorgesehen sind.

8. Anordnung nach einem der Ansprüche 4 bis 7, dadurch gekennzeichnet, daß an den beiden Eingängen des Phasennetzwerks (SPG) jeweils ein Verstärker mit Differenzausgängen angeordnet ist, der eine invertierte und eine nicht invertierte Signalkomponente abgibt.

**Claims**

1. Phase-to-digital conversion method for phase-modulated signals, in which method an analog input signal $\underline{s}(t)$ is resolved into orthogonal signal components $x(t)$ and $y(t)$ and a phase network (SPG) operating in analog with $2^N$ sign comparators ($VK_1$ to $VK_n$) connected therebehind is used for phase resolution into $2^N$ equal phase increments $\theta = 2\pi.2^{-N}$, wherein N is an integral number,

- wherein the sign comparators ($VK_1$ to $VK_n$) each time produce a digital phase signal $sq_i$ corresponding to the sign, wherein $i = 1$ to $2^{N-1}$, from displaced signal phases $\phi_i(t)$, wherein $\phi_i(t) = a_i \cdot x(t) + b_i \cdot y(t)$ and i can be equal to 1 to $2^{N-1}$ and the condition $b_i/a_i = \tan\theta_i$, wherein $\theta_i = \theta.(i-1)$, applies for the weighting co-efficients $a_i$ and $b_i$ and/or for the weighted signal components $a_i.x(t)$, $-a_i.x(t)$, $b_i.x(t)$ and $-b_i.x(t)$ for each $\phi_i(t)$, wherein $i = 1$ to $2^{N-1}$ and

- wherein the digital phase signals $sq_i(t)$ are simultaneously scanned at a pulse rate ($k.T_A$) for phase demodulation so that a time-discrete sequence of digital phase words ($\phi(k)$) arises.

2. Method according to claim 1, characterised thereby, that for $N > 2$, the formation of the signal phases $\phi_i$ takes place in several successive steps, wherein the phase increment is halved from step to step and the signal phases belonging to the individual phase steps are obtained from the scaled signal phases of the preceding step.

3. Method according to claim 1 or 2, characterised thereby, that the digital phase signals $sq_i(t)$ are scanned at a scanning frequency which is at least equal to the bandwidth of the input signal $\underline{s}(t)$.

4. Arrangement for the performance of the method according to claim 1 and displaying

- a mixer arrrangement (QM) for the production of orthogonal signal components $x(t)$ and $y(t)$ from the analog input signal $\underline{s}(t)$,
- an arrangement of a phase network (SPG) operating in analog and $2^N$ sign comparators ($VK_1$ to $VK_n$) connected therebehind, wherein sign comparators ($VK_1$ to $VK_n$) receive displaced signal phases $\phi_i(t)$, wherein $\phi_i(t) = a_i.x(t) + B_i.y(t)$ and i can be equal to 1 to $2^{N-1}$ and the condition $b_i/a_i = \tan \theta_i$, wherein $\theta_i = \theta.(i-1)$, applies for the weighting co-efficients $a_i$ and $b_i$ and/or weighted signal components $a_i.x(t)$, $-a_i.x(t)$, $b_i.x(t)$ and $-b_i.x(t)$, from the phase network (SPG) and
  produce a digital phase signal $sq_i(t)$, wherein i = 1 to $2^{N-1}$, for each $\phi_i(t)$, wherein i = 1 to $2^{N-1}$, and each time corresponding to the sign and
- a digital sequence scanner (DSA), which scans the digital phase signals $sq_i(t)$ at a pulse rate ($k.T_A$) for phase demodulation.

5. Arrangement according to claim 4, characterised thereby, that the orthogonal signal components $x(t)$ and $y(t)$ are present each time in parallel at several amplitude-weighting members ($V_x$, $V_y$, VD) in the phase network, which operates in analog, for the production of weighted signal components $a_i.x(t)$ and $b_i y(t)$ as well as signal components $-a_i.x(t)$ and $-b_i.y(t)$ inverted relative thereto.

6. Arrangement according to claim 4 or 5, characterised thereby, that the amplitude-weighting members are active amplifying elements with preset amplification factors.

7. Arrangement according to claim 4, characterised thereby, that differential amplifiers (VD) of equal amplification factor within one stage are provided for the combination of two signal phases of the respectively preceding step and for the scaling of the signal phase resulting therefrom.

8. Arrangement according to one of the claims 4 to 7, characterised thereby, that a respective amplifier with differential outputs, which delivers an inverted and a non-inverted signal component, is arranged at each of both the inputs of the phase network (SPG).

**Revendications**

1. Procédé de conversion phase/numérique pour signaux modulés en phase, selon lequel un signal analogique d'entrée $\underline{s}(t)$ est décomposé en composantes de signal orthogonales $x(t)$ et $y(t)$ et selon lequel, pour la résolution numérique en phase en $2^N$ incréments de phase égaux $\theta = 2\pi \cdot 2^{-N}$, où N est un nombre entier, un réseau de phase (SPG), à fonctionnement analogique, est utilisé ensemble avec $2^N$ comparateurs de signes ($VK_1$ à $VK_n$) montés à sa suite,

   dans lequel les comparateurs de signes ($VK_1$ à $VK_n$) génèrent chaque fois un signal numérique de phase $sq_i$, où i = 1 à $2^{N-1}$, signal qui correspond au signe, à partir de phases de signal décalées $\phi_i(t)$, où $\phi_i(t) = a_i \cdot x(t) + b_i \cdot y(t)$ et i = 1 à $2^{N-1}$, les coefficients pondéraux $a_i$ et $b_i$ répondant à la condition $b_i/a_i = \tan \theta_i$, où $\theta_i = \theta \cdot (i-1)$, et/ou à partir des composantes de signal pondérées $a_i \cdot x(t)$, $-a_i \cdot x(t)$, $b_i \cdot x(t)$, $-b_i \cdot x(t)$, pour chaque $\phi_i(t)$, où i = 1 à $2^{N-1}$, et dans lequel les signaux numériques de phase $sq_i(t)$, en vue de la démodulation de phase, sont simultanément échantillonnés à un rythme ($k \cdot T_A$), de sorte qu'il se forme une suite discrète dans le temps de mots de phase numériques ($\phi(k)$).

2. Procédé selon la revendication 1, caractérisé en ce que, pour N > 2, la formation des phases de signal $\phi_i$ s'effectue en plusieurs étapes successives, l'incrément de phase étant divisé par deux d'une étape à l'autre et les phases de signal appartenant aux différentes étapes de formation de phases étant obtenues à partir des phases de signal mises à l'échelle de l'étape précédente.

3. Procédé selon la revendication 1 ou 2, caractérisé en ce que les signaux numériques de phase $sq_i(t)$ sont échantillonnés à une fréquence d'échantillonnage au moins égale à la largeur de bande du signal d'entrée $\underline{s}(t)$.

**4.** Dispositif pour la mise en oeuvre du procédé selon la revendication 1, comprenant

- un dispositif mélangeur (QM) pour générer des composantes de signal orthogonales $x(t)$, $y(t)$ à partir d'un signal analogique d'entrée $\underline{s}(t)$,
- un dispositif composé d'un réseau de phase (SPG) à fonctionnement analogique et de $2^N$ comparateurs de signe (VK$_1$ à VK$_n$) montés à la suite de ce réseau, les comparateurs de signes (VK$_1$ à VK$_n$) recevant du réseau de phase (SPG)
  des phases de signal décalées $\phi_i(t)$, où $\phi_i(t) = a_i \cdot x(t) + b_i \cdot y(t)$ et $i = 1$ à $2^{N-1}$, les coefficients pondéraux $a_i$ et $b_i$ répondant à la condition $b_i/a_i = \tan \phi_i$, où $\phi_i = \phi \cdot (i-1)$, et/ou
  des composantes de signal pondérées $a_i \cdot x(t)$, $-a_i \cdot x(t)$, $b_i \cdot x(t)$, $-b_i \cdot x(t)$
  et générant pour chaque $\phi_i(t)$, où $i = 1$ à $2^{N-1}$, chaque fois un signal de phase $sq_i(t)$, où $i = 1$ à $2^{N-1}$, signal qui correspond au signe, et
- un échantillonneur numérique de séquences (DSA) qui échantillonne les signaux numériques de phase $sq_i(t)$ avec le rythme $(k \cdot T_A)$ en vue de la démodulation de phase.

**5.** Dispositif selon la revendication 4, caractérisé en ce que les composantes de signal orthogonales $x(t)$ et $y(t)$ dans le réseau de phase (SPG) à fonctionnement analogique, sont appliquées chaque fois en parallèle à plusieurs éléments de pondération d'amplitude ($V_x$, $V_y$, VD) en vue de la génération de composantes de signal pondérées $a_i \cdot x(t)$ et $b_i \cdot y(t)$, ainsi que de composantes de signal $-a_i \cdot x(t)$ et $-b_i \cdot y(t)$ inversées par rapport à elles.

**6.** Dispositif selon la revendication 4 ou 5, caractérisé en ce que les éléments de pondération d'amplitude sont des éléments d'amplification utilisant des facteurs d'amplification préfixés.

**7.** Dispositif selon la revendication 4, caractérisé en ce que, pour la réunion de deux phases de signal de l'étape chaque fois précédente et pour la mise à l'échelle de la phase de signal qui en résulte, on a prévu des amplificateurs différentiels (VD) ayant le même facteur d'amplification dans une même étape.

**8.** Dispositif selon une des revendications 4 à 7, caractérisé en ce qu'un amplificateur à sorties différentielles est disposé à chacune des deux entrées du réseau de phase (SPG), amplificateur qui délivre une composante de signal inversée et une composante de signal non inversée.

a)

b)

FIG.1

EP 0 335 284 B1

FIG. 2

EP 0 335 284 B1

FIG.3

FIG.4

FIG.5

15

FIG.6

FIG.7

EP 0 335 284 B1

FIG. 8

FIG.9

18

FIG. 10